(19) Europäisches Patentamt
European Patent Office
Office européen des brevets

(11) **EP 1 088 338 B1**

(12) **EUROPEAN PATENT SPECIFICATION**

(45) Date of publication and mention of the grant of the patent:
**21.03.2007 Bulletin 2007/12**

(51) Int Cl.:
***H01L 21/00*** *(2006.01)*

(21) Application number: **00926794.9**

(22) Date of filing: **03.04.2000**

(86) International application number:
**PCT/EP2000/002959**

(87) International publication number:
**WO 2000/062332 (19.10.2000 Gazette 2000/42)**

(54) **ARRANGEMENT FOR STORING OBJECTS, PARTICULARLY FOR STORING DISKLIKE OBJECTS SUCH AS WAFERS, FLAT PANELS OR CDs**

ANORDNUNG ZUR LAGERUNG VON GEGENSTÄNDEN, INSBESONDERE VON SCHEIBENFÖRMIGEN GEGENSTÄNDEN, WIE WAFERN, FLACHEN PANELEN, ODER CDS

ARRANGEMENT POUR LE RANGEMENT D'OBJETS, NOTAMMENT D'OBJETS DU TYPE DISQUE, TELS QUE DES PLAQUETTES, DES PANNEAUX PLATS OU DES CD

(84) Designated Contracting States:
**DE FR GB IE IT**

(30) Priority: **13.04.1999 EP 99107204**

(43) Date of publication of application:
**04.04.2001 Bulletin 2001/14**

(73) Proprietor: **Infineon Technologies SC300 GmbH & Co. OHG**
**01099 Dresden (DE)**

(72) Inventors:
• **MISSALE, Reiner**
  **D-93155 Hemau (DE)**
• **HAHN, Sven**
  **D-01139 Dresden (DE)**

(74) Representative: **Epping - Hermann - Fischer Patentanwaltsgesellschaft mbH**
**Ridlerstrasse 55**
**80339 München (DE)**

(56) References cited:
EP-A- 0 827 194      GB-A- 2 292 636
US-A- 4 757 355      US-A- 4 867 629

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

The present invention relates to an arrangement for storing disklike objects such as wafers, flat panels or CDs.

In the technical field of manufacturing and processing wafers (for example disks on the basis of silicon, flat panels or CDs) in the semiconductor industry it is common and necessary that wafers are frequently moved between different processing stations. Nevertheless, there is a need to store said wafers in such cases that they are not needed for the moment or before they are moved to a next processing station respectively.

As an example, so-called test wafers are used in process systems for process control, for affecting cleaning tools, for checking processing tools, for testing new products and so forth. These test wafers are frequently circulated in the system for manufacturing and processing wafers, i.e. they are currently moved between different processing stations. However, said different test wafers are not necessarily used throughout the whole time. Therefore, they have to be stored in an arrangement for storing wafers in case that they are not needed.

Usually, wafers are stored in currently automated storage arrangements under minienvironment conditions. In the light of the present invention, the term minienvironment defines a localized environment created by an enclosure to isolate a product from contamination and people. The requirements for such minienvironments are set forth in SEMI-standards E44 for example.

In known arrangements, storage and retrieval of wafers is either performed in containers or as bare wafers.

In the latter case, the wafers are stored in a storage cabinet including a number of open structured compartements which are adapted to store those wafers. To load/unload a wafer from a compartement a movable means for handling said wafers is provided. Said means can be formed as a robot which grips a selected wafer and moves it to a load port of the arrangement from where it is transported to the destined processing station. Although a storage of bare bare wafers is very fast with regard to the handling time, it bears severeal drawbacks. Since the wafers are stored in open structured compartments they are exposed to risks like a cross-contamination based on outgassing for example or like a contamination of the entire stock based on a possible wafer breakage.

On the other hand, it is known to store wafers in an arrangement which stores containers. In this case the wafers are stored within said containers. Usually, the containers are locked by a door. In order to select a wafer from a container, the container has to be moved by a container handling means -for example a robot- to a load/unload station, which is stationary provided in the arrangement for storing wafers.

This load/unload station comprises a device for opening/closing the door of the container, a device for loading/unloading a wafer from the container and for transporting the selected wafer to a load port from which said wafer is transported to the respective processing station. A load/unload station of the known type is specified by SEMI-standard E62 for example. By use of such an arrangement, a contamination of the wafers can be prevented since the containers are sealed by the closed container door.

However, wafer storage in the described manner is very complex in constructional manner and furthermore, it is very time consuming.

Firstly, the arrangement has to be provided with a separate load/unload station for the containers. Said station requires a specific door alignment mechanism, a locking/unlocking mechanism for the container doors, specific seal zones and other means for loading/unloading the wafers from the containers. This is very complex under the contructional viewpoint. Additionally, the selected container has to be placed exactly within said load/unload station in order to avoid a damage of the wafers during the load/unload step. Thus, several control means are required. Finally, separate means for handling the container are required.

The aforementioned way of storing wafers requires both the handling of the containers to the load/unload station and the handling from the wafers at the load/unload station. This is very time consuming.

In view of the prior art it is an object of the present invention to provide an arrangement for storing objects which overcomes the aforementioned drawbacks.

This object is solved by the arrangement according to independent claim 1 and by the use of an arrangement according to independent claim 13. Further advantages, features, aspects and details of the invention are evident from the dependent claims, the description and the accompanying drawings.

According to the present invention an arrangement for storing objects is provided, which stores said objects in containers but does not have a means for handling said containers. Therefore, the containers remain in a stationary position at least during the load/unload operation. The containers only have to be removed (advantageously manually) from the storage cabinet for reasons of cleaning and maintenance.

Instead of moving the containers, a movable door opening means is provided, which can be moved to the stationary containers to lock/unlock the container door and give access to the objects for said movable means for handling said objects. Therefore, the invention comprises a door opening means, which is not, as common standard in the industry, a stationary part of a load/unload station. Said means can be freely positioned and moved within a defined area. It opens the door of the container without moving the entire container.

For that reason a significant saving of handling time can be obtained.

The arrangement according to the present invention is also superior to the solution of storing bare objects. Upon the fact that the objects are stored in containers which are usually closed by a door, unless an object is inserted or removed from the container, a contamination of said objects or a damage thereof and thus a contamination of the entire stock by a breakage of an object can be prevented.

The invention ist not limited to being suitable for specific kinds of disk-like objects. Therefore, the arrangement according to the invention is suitable for all sorts of disk-like objects which preferably have to be stored under minienvironment conditions. The term minienvironment has already been explained in the introducory part of the description.

Advantageously, the arrangement is used to store disklike objects such as wafers, flat panels or CDs. Particularly the arrangement is used to store wafers with a diameter up to and beyond 300mm.

The arrangement can be used to store wafers, which are frequently moved between different containers. Such wafers are for example test wafers, ANKO (Anlagen-Kontrolle (system check)) wafers, production disks and so forth. The invention is not limited to the mentioned examples.

In case that the arrangement is used to store wafers, said door opening means may be designed according to SEMI-Standard E62. The door opening means according to the present invention is not a stationary part of a FIMS (Front-Opening-Interface-Mechanical-Standard) interface or loadport as specified in SEMI E62.

The advantage of such an arrangement is that wafers which are moved between different containers frequently can be stored in a container and an automated handling system can be designed around it to automatically compose an individual container content of wafers from the contents of various other containers. For this operation, no means for the handling of containers is required, hence a saving in handling time is achieved.

According to the present invention, said door opening means is designed to unlock and open the door of a respective container. Furthermore the door can be removed from the container by the door opening means. Under these circumstances, the door opening means may hold the door while said means for handling said objects (wafers) grips and moves the objects. Alternatively, the door opening means may deposit the door inside the storage cabinet and pick it up after the operation is finished. However, the invention ist not limited to the described examples.

Said movable means for handling said objects and said door opening means is arranged/combined to a single device for loading/unloading said objects. Such a single device is not very complex under constructional viewpoints. Furthermore, a single device does not require much space. Additionally, only one control unit is required for controlling said device. The combination of both means to one single device is possible, since the step of opening the door of a container and the load/unload step of an object are performed subsequently.

Preferably, the device for loading/unloading the objects is formed as a robot, particularly as a robot arm. A robot is movable in all possible directions. Thus, the storage cabinet can get complemented with containers in a close-packed way. If the arrangement is used to store wafers, the device for loading/unloading can be a wafer handling robot including as an additional feature the door opening means.

Furthermore, a control unit may be provided for controlling said means for handling the objects and/or said door opening means and/or said device for loading/unloading said objects. Said control unit can be used to move said means or the device to a selected container. Furthermore, it can control the opening/closing operation of the container doors. Moreover, it can manage the sorting of the objects, for example the wafers in said containers during the storage operation. Thus it may control the wafer management, for example the test wafer management in and for different containers.

Said storage cabinet is formed as a closed system and provides minienvironment conditions, thus a contamination of the stored objects can be prevented. This is particularly suitable for the storage of wafers in the semiconductor industry.

Preferably, said means for opening the doors comprises means for holding and/or removing a door of a container. Such means are described for example in SEMI-Standards E62 and E63.

In a preferred embodiment, said means for holding and/or removing the door comprises suction means such as suction cups and/or door opening keys and/or pins and/or gripping means. These means can be SEMI E62 compliant means for example. Such means may comprise door alignment means like registration pins, locking means like latch keys, suction cups for holding and removing the container door and so forth. It should be self-evident that the described means are to be understood as non-limiting examples for said means for holding and/or removing the door.

Preferably, said means for handling the objects may comprise suction means such as suction cups and/or gripping means. The present invention is not limited to the described specific embodiments. All kinds of means for handling said objects can be used which are able to move said objects within said arrangement for storing objects without damaging or contaminating same.

Advantageously, said container for storing the objects may be formed as a box comprising a box housing and a box opening, said box opening being locked by said door. Such a box can be a protective portable container. Advantageously, said box can be performed as a FOUP (Front Opening Unified Pod), which is defined in SEMI-Standards E44 and E62.

The box is configured to store more than one object. In case that the box is used to store wafers it may be adapted to support 13, 25 or 50 wafers for example.

The box can also be designed according to SEMI-Standard E47.1. According to said standard, the box has a door and a box housing. On the top of the box housing a top handling flange may be provided which enables an Automated Material Handling System (AMHS) to transport the box. Additionally, side handles may be provided which enable an operator to manually carry the box. Furthermore, the box may comprise holes for registration pins, door sensing pads and optionally conveyor rails and handles on its sides. The conveyor rails serve to store the box within the storage cabinet. At the bottom of said box, conveyor rails can be optionally provided. Moreover, the bottom can have various sensing pads, info pads, pins and so forth.

Preferably, said door of the box may be provided at the front side. If the box is formed as a FOUP, the door is arranged at the front side of the box.

Advantageously, a sealing means may be provided between said box housing and said door. Such a sealing means has the effect, that the objects stored in said containers are additionally protected of contamination, if the doors are closed.

Preferably, one or more cassettes for storing said objects are provided, said cassettes being stored within said container. A cassette is an open structure that holds one or more objects, for example wafers. The cassettes can be removably or non-removably stored within said box.

A container for storing such objects which have been removed from the containers, is provided. Said container serves to store those objects which have been removed from various different containers within said storage cabinet to compose a new individual lot of objects. The objects can be transported within said container to a selected location of the processing system.

Advantageously said movable means for handling the objects and said means for opening the doors and/or said container for storing such objects which have been removed from the containers may be located within said storage cabinet. Particularly, since the storage cabinet is held under minienvironment conditions, a contamination of the objects during the load/unload step can be prevented.

Preferably, a head port may be provided, said head port being connected to said storage cabinet. Advantageously, said head port may comprise a locking system. Through such a head port, the selected objects can be removed from the inside of the storage cabinet. The locking system may comprise a door, a hinged plate, a lock and so forth.

The arrangement according to the present invention can lead to a significant saving of handling time, as the following example illustrates:

According to the example, the preset task is to compose a lot of 25 wafers from 5 FOUP'S. It is assumed that the cycle time per FOUP move is 30sec., the door open and close sequence of a known arrangement is 5sec., the door open and close sequence of an arrangement according to the present invention is 7sec., the wafer handling sequence of a known arrangement is 10sec. and the wafer handling sequence of an arrangement according to the present invention is 15sec..

Under these conditions, the traditional operation of a known arrangement with separate FOUP handling means lasts 660sec., based on the following formula:

```
12 FOUP moves * 30sec. + 10 open/close operations * 5sec. +
25 wafer moves * 10sec. = 660 sec.
```

The new operation with an arrangement according to the present invention lasts only 445sec, based on the following formula:

```
10 open/close operations * 7sec. + 25 wafer moves * 15sec.
= 445 sec.
```

The saving in handling time in the example is about 3.6 minutes or 33%.

The invention will be better understood by reference to the following description of embodiments of the invention taken in conjunction with the accompanying drawings, wherein:

Fig.1 shows a schematic top view of an arrangement for storing objects according to an embodiment of the present invention; and

Fig.2 shows a schematic side view of a container for storing objects.

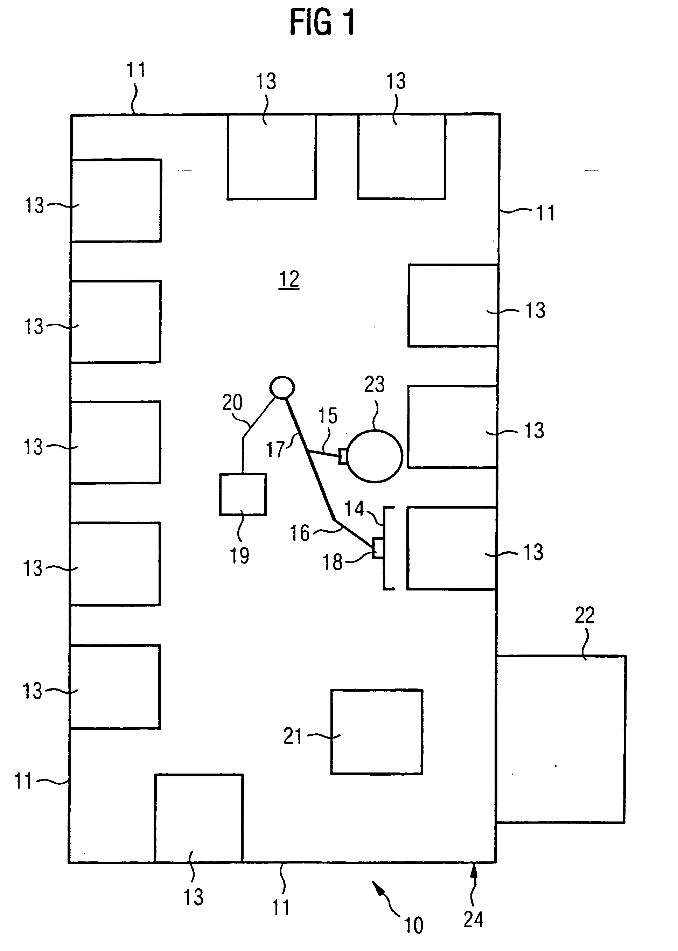

In Fig.1 an arrangement 10 is illustrated which serves to store wafers 23. Said arrangement 10 is used in the field of semiconductor or CD technology, namely to manufacture process wafers 23. Fig.1 is a schematic top view to said arrangement 10. For a better view, the lid of arrangement 10 has been removed.

Arrangement 10 comprises a storage cabinet 24 with four sidewalls 11. The storage cabinet 24 is formed as a closed system 12 with minienvironment conditions within storage cabinet 24. At the sidewalls 11, a number of containers 13 for storing wafers 23 is installed. The arrangement 10 comprises several rows of containers 13. In Fig.1 only the top row is illustrated which comprises eleven containers 13. Inside each container 13, thirteen, twenty-five or fifty wafers 23 can be stored.

In order to load/unload wafers 23 from said containers 13, means 15 for handling such wafers 23 are provided. For handling the wafers 23, said means 15 may comprise suction means such as suction cups and/or gripping means.

Furthermore, door opening means 16 are provided which may open doors 14 of the containers 13. Said door opening means 16 comprise means 18 for holding and/or removing said door 14, such as suction means and/or door opening keys and/or pins and/or gripping means.

Said means 15 for handling said wafers 23 and said door opening means 16 are arranged/combined to a single device 17 for loading/unloading said wafers 23. Device 17 is formed as a robot, in the present embodiment as a robot arm. Thus, both means 15 and 16 are movably arranged within said storage cabinet 24, whereby said means 15, 16 may be freely moved in all directions. The length of said robot arm may be varied in telescopic manner, if desired.

In order to control the movement of device 17 and/or means 15 and 16, a control unit 19 is provided, wich is connected via a conduit 20 to device 17 and/or means 15, 16 respectively.

In order to compose those wafers 23, which have been removed from several containers 13 to a new lot of wafers 23, that is to be transported from the storage cabinet 24 to other processing units in a process system, container 21 for storing such wafers 23 are provided.

For removing wafers 23 or means 21 from storage cabinet 24, a head port 22 ist provided, which ist connected to storage cabinet 24. Said head port 22 may be formed as a lock or a door. Since minienvironment conditions are installed within the storage cabinet 24, head port 22 ist preferably formed as a lock, in order to avoid any contamination within storage cabinet 24.

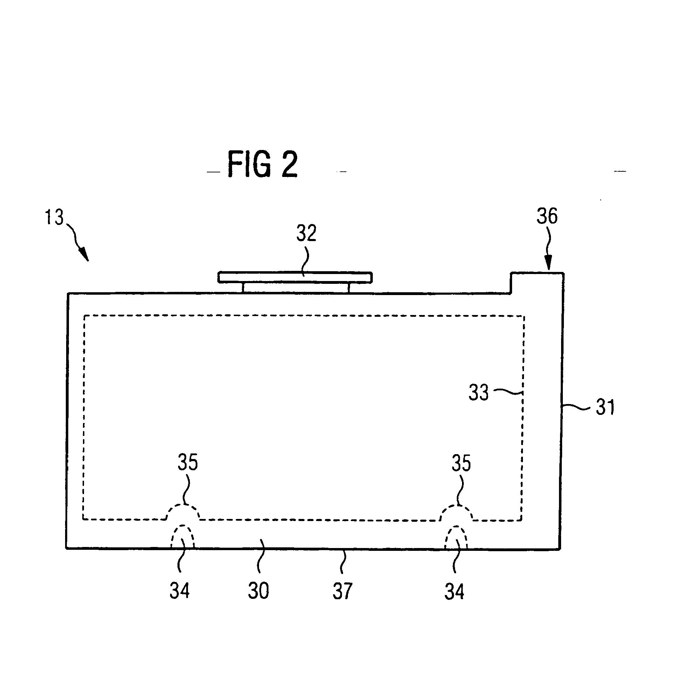

Fig.2 shows a container 13 that is formed as a box. The box 13 comprises a box housing 30 and a box opening 31. The door 14, which has been removed from the box 13 according to Fig.2 is normally provided at front side 36 of box 13. In a different embodiment, door 14 could also be provided in the bottom 37 of box 13. Box 13 further comprises a top handling flange 32 by aid of which said box can be carried by an Automated Material Handling System.

For storing wafers 23 in box 13 a cassette 33 is provided. Since cassette 33 is stored within box 13 it is shown in dotted lines. In order to fix cassette 33 into box 13, holes 35 and pins 34 are provided respectively.

In the following, the operation of arrangement 10 is described.

Contrary to those solutions which are known from the prior art, arrangement 10 according to the present invention comprises a movable door opening means 16 which is not a stationary part of a separate load/unload system, to which a container 13 has to be moved for being loaded/unloaded with wafers 23. Instead of this, door opening means 16 is attached to a robot arm 17 within storage cabinet 24. The robot arm 17 can position door opening means 16 freely within a defined area. Door opening means 16 opens container door 14 and removes it without removing the entire container 13.

The advantage of said arrangement 10 is that wafers 23 which are moved between different containers 13 frequently (for example test wafers) can be stored in a container 13 and an automated device 17 for loading/unloading wafers 23 is designed around it to automatically compose a lot of wafers 23 in container 21 from contents of various other containers 13 without the requirement of means for handling said containers 13. The containers 13 are stationary arranged within storage cabinet 24 and the door 14 is unlocked and removed by door opening means 16 and means 18 for holding/removing door 14. The door opening means 16 may either hold the door 14 while means 15 for handling wafers 23 moves the wafers 23 within storage cabinet 24. Otherwise it is possible that door 14 is deposited inside storage cabinet 24 and picked up again after termination of the storage operation.

With arrangement 10 according to the present invention a significant saving of handling time can be obtained.

**Claims**

1. An arrangement (10) for storing disk-like objects, comprising:

a storage cabinet (24) being a closed system (12) having mini-environment conditions, said storage cabinet (24) storing a plurality of containers (13) configured to store a plurality of disk-like objects (23) therein, said containers (13) being locked by a respective removable door (14);

an additional container (21) transportable into and out of said storage cabinet (24), said storage cabinet (24) being configured to store said additional container (21);

a load/unload device (17) for loading/unloading the plurality of objects (23), having a movable object-handling device (15) and a door-opening device (16) integrated into said load/unload device (17);

said load/unload device (17) configured for loading and unloading the objects (23) from said containers (13), said load/unload device (17) being configured for loading said additional container (21) with objects (23) unloaded from one of said containers (13); and

said door-opening device (16) movably disposed to approach said containers (13) and configured to open said removable doors (14) by removing said removable doors (14) and close said removable doors (14) of said containers (13) while said movable object-handling device (15) is designed to perform one of the load-operation and unload-operation with respect to at least one of said containers (13) within said storage cabinet (24).

2. Arrangement according to claim 1,
**characterized in**
**that** said load/unload device (17) is formed as a robot, particularly as a robot arm.

3. Arrangement according to any of claims 1 to 2,
**characterized in**
**that** a control unit (19) is provided for controlling at least one of moveable object-handling device (15) for handling said objects (23) and said door opening device (16) and said load/unload device (17).

4. Arrangement according to any of claims 1 to 3,
**characterized in**
**that** said door opening device (16) comprises means (18) for holding one of said removable doors (14).

5. Arrangement according to claim 4,
**characterized in**
**that** said means (18) for holding one of said removable doors (14) comprises suction means such as suction cups and/or door opening keys and/or pins and/or gripping means.

6. Arrangement according to any of claims 1 to 5,
**characterized in**
**that** said movable object-handling device (15) comprises suction means such as suction cups and/or gripping means.

7. Arrangement according to any of claims 1 to 6,
**characterized in**
**that** one of the plurality of containers (13) is formed as a box comprising a box housing (30) and a box opening (31), said box opening (31) being locked by a respective removable door (14).

8. Configuration according to claim 7,
**characterized in**
**that** said respective removable door (14) is provided at the front side (36) or in the bottom (37) of said box.

9. Arrangement according to any of claims 7 or 8,
**characterized in**
**that** a sealing means is provided between said box housing (30) and said respective removable door (14).

10. Arrangement according to any of claims 7 to 9,
**characterized in**
**that** one or more cassettes (33) for storing said objects (23) are provided, said cassettes (33) being stored within one of the plurality of containers (13).

11. Arrangement according to any of claims 1 to 10,
**characterized in**
**that** a head port (22) is provided, said head port (22) being connected to said storage cabinet (24).

12. Arrangement according to claim 11,

**characterized in**
**that** said head port (22) comprises a locking system.

13. Use of an arrangement (10) according to any of claims 1 to 12 for storing wafers (23), particularly for storing wafers with a diameter up to and beyond 300 mm.


**Patentansprüche**

1. Anordnung (10) zur Lagerung von scheibenförmigen Gegenständen, die folgendes umfaßt:

   - einen Lagerschrank (24), der als ein geschlossenes System (12) ausgeführt ist, in dem Miniumgebungsbedingungen herrschen, wobei im Lagerschrank (24) mehrere Behältnis (13) gelagert werden können, die konfiguriert sind, um darin mehrere scheibenförmige Gegenstände (23) lagern zu können, wobei die Behältnis (13) durch eine jeweilige entfernbare Tür (14) verriegelt sind;
   - einen zusätzlichen Behältnis (21), der in den Lagerschrank (24) hinein- und daraus heraustransportiert werden kann, wobei der Lagerschrank (24) für die Lagerung des zusätzlichen Behältnisses (21) konfiguriert ist;
   - eine Handhabungs-Vorrichtung (17) zum Laden/Entladen der mehreren Gegenstände (23), wobei eine bewegbare Gegenstandhandhabungsvorrichtung (15) und eine Türöffnungsvorrichtung (16) in die Vorrichtung (17) integriert sind;
   - wobei die Handhabungs-Vorrichtung (17) für das Laden und Entladen der Gegenstände (23) aus den Behältnissen (13) konfiguriert ist, wobei die Gegenstandhandhabungsvorrichtung (17) für das Laden des zusätzlichen Behältnisses (21) mit aus einem der Behältnis (13) entladenen Gegenständen (23) konfiguriert ist; und
   - wobei die Türöffnungsvorrichtung (16), um sich den Behältnissen (13) nähern zu können, bewegbar vorgesehen und konfiguriert ist, um die entfernbaren Türen (14) durch Entfernen der entfernbaren Türen (14) zu öffnen und die entfernbaren Türen (14) der Behältnis (13) zu schließen, während die bewegbare Gegenstandhandhabungsvorrichtung (15) ausgeführt ist, um entweder den Ladevorgang oder den Entladevorgang im Verhältnis zu mindestens einem der Behältnis (13) innerhalb des Lagerschranks (24) durchzuführen.

2. Anordnung nach Anspruch 1, **dadurch gekennzeichnet, daß** die Lade-/Entlade-Vorrichtung (17) als ein Roboter, insbesondere als ein Roboterarm, ausgebildet ist.

3. Anordnung nach einem der Ansprüche 1 bis 2, **dadurch gekennzeichnet, daß** eine Steuerungseinheit (19) vorgesehen ist, um mindestens die bewegbare Gegenstandhandhabungsvorrichtung (15) zur Handhabung der Gegenstände (23) oder die Türöffnungsvorrichtung (16) oder die Lade-/Entlade-Vorrichtung (17) zu steuern.

4. Anordnung nach einem der Ansprüche 1 bis 3, **dadurch gekennzeichnet, daß** die Türöffnungsvorrichtung (16) ein Mittel (18) zum Halten von einer der entfernbaren Türen (14) umfaßt.

5. Anordnung nach Anspruch 4, **dadurch gekennzeichnet, daß** das Mittel (18) zum Halten von einer der entfernbaren Türen (14) Saugmittel, wie beispielsweise Saugnäpfe, und/oder Türöffnungstasten und/oder Stifte und/oder Greifmittel umfaßt.

6. Anordnung nach einem der Ansprüche 1 bis 5, **dadurch gekennzeichnet, daß** die bewegbare Gegenstandhandhabungsvorrichtung (15) Saugmittel, wie beispielsweise Saugnäpfe, und/oder Greifmittel umfaßt.

7. Anordnung nach einem der Ansprüche 1 bis 6, **dadurch gekennzeichnet, daß** einer der mehreren Behältnis (13) als ein Box ausgebildet ist, der ein Boxgehäuse (30) und eine Boxöffnung (31) umfaßt, wobei die Boxöffnung (31) durch eine jeweilige entfernbare Tür (14) verriegelt ist.

8. Anordnung nach Anspruch 7, **dadurch gekennzeichnet, daß** die jeweilige entfernbare Tür (14) an der Vorderseite (36) oder im Boden (37) der Box vorgesehen ist.

9. Anordnung nach einem der Ansprüche 7 oder 8, **dadurch gekennzeichnet, daß** ein Dichtungsmittel zwischen dem Boxgehäuse (30) und der jeweiligen entfernbaren Tür (14) vorgesehen ist.

10. Anordnung nach einem der Ansprüche 7 bis 9, **dadurch gekennzeichnet, daß** eine oder mehrere Kassetten (33) zur Lagerung der Gegenstände (23) vorgesehen sind, wobei die Kassetten (33) innerhalb eines der mehreren Behältnis (13) gelagert sind.

**11.** Anordnung nach einem der Ansprüche 1 bis 10, **dadurch gekennzeichnet, daß** eine Kopföffnung (22) vorgesehen ist, wobei die Kopföffnung (22) mit dem Lagerschrank (24) verbunden ist.

**12.** Anordnung nach Anspruch 11, **dadurch gekennzeichnet, daß** die Kopföffnung (22) ein Verriegelungssystem umfaßt.

**13.** Verwendung einer Anordnung (10) nach einem der Ansprüche 1 bis 12 zur Lagerung von Wafern (23), insbesondere zur Lagerung von Wafern mit einem Durchmesser von bis zu und mehr als 300 mm.

**Revendications**

**1.** Agencement (10) pour le rangement d'objets du type disque, comprenant :

une armoire de rangement (24) qui est un système fermé (12) ayant des conditions de mini-ambiance, l'armoire de rangement (24) contenant une pluralité de conteneurs (13) configurés de telle sorte qu'une pluralité d'objets du type disque (23) puissent y être rangés, lesdits conteneurs (13) étant verrouillés par une porte amovible respective (14) ;
un conteneur supplémentaire (21) pouvant être transporté vers l'intérieur et vers l'extérieur de l'armoire de rangement (24), l'armoire de rangement (24) étant configurée de telle sorte que le conteneur supplémentaire (21) puisse y être rangé ;
un dispositif de chargement/déchargement (17) pour le chargement/déchargement de la pluralité d'objets (23), un dispositif de manipulation d'objets mobile (15) et un dispositif d'ouverture de porte (16) étant intégrés dans le dispositif de chargement/déchargement (17) ;
le dispositif de chargement/déchargement (17) étant configuré de manière à charger et décharger les objets (23) dans et depuis lesdits conteneurs (13), le dispositif de chargement/déchargement (17) étant configuré de manière à charger le conteneur supplémentaire (21) avec des objets (23) déchargés de l'un desdits conteneurs (13) ; et
le dispositif d'ouverture de porte (16) étant disposé de manière mobile, de façon à pouvoir approcher desdits conteneurs (13), et étant configuré de manière à ouvrir les portes amovibles (14) en retirant les portes amovibles (14) et à fermer les portes amovibles (14) desdits conteneurs (13), tandis que le dispositif de manipulation d'objets mobile (15) est conçu pour exécuter l'une des opération de chargement et opération de déchargement par rapport à au moins l'un desdits conteneurs (13) rangés dans l'armoire de rangement (24).

**2.** Agencement selon la revendication 1, **caractérisé en ce que** le dispositif de chargement/déchargement (17) se présente sous la forme d'un robot, en particulier sous la forme d'un bras robotisé.

**3.** Agencement selon l'une quelconque des revendications 1 à 2, **caractérisé en ce qu'**une unité de commande (19) est prévue pour commander au moins l'un du dispositif de manipulation d'objets mobile (15) servant à manipuler lesdits objets (23), dudit dispositif d'ouverture de porte (16) et dudit dispositif de chargement/déchargement (17).

**4.** Agencement selon l'une quelconque des revendications 1 à 3, **caractérisé en ce que** le dispositif d'ouverture de porte (16) comprend des moyens (18) servant à tenir l'une des portes amovibles (14).

**5.** Agencement selon la revendication 4, **caractérisé en ce que** lesdits moyens (18) servant à tenir l'une des portes amovibles (14) comprennent des moyens d'aspiration tels que des ventouses et/ou des clés d'ouverture de porte et/ou des broches et/ou des moyens de préhension.

**6.** Agencement selon l'une quelconque des revendications 1 à 5, **caractérisé en ce que** le dispositif de manipulation d'objets mobile (15) comprend des moyens d'aspiration tels que des ventouses et/ou des moyens de préhension.

**7.** Agencement selon l'une quelconque des revendications 1 à 6, **caractérisé en ce que** l'un des différents conteneurs (13) se présente sous la forme d'une boîte ayant un corps de boîte (30) et une ouverture de boîte (31), l'ouverture de boîte (31) étant verrouillée par une porte amovible respective (14).

**8.** Agencement selon la revendication 7, **caractérisé en ce que** la porte amovible respective (14) est disposée au niveau de la face avant (36) ou dans le fond (37) de la boîte.

9. Agencement selon l'une quelconque des revendications 7 ou 8, **caractérisé en ce que** des moyens de fermeture étanche sont prévus entre le corps de boîte (30) et la porte amovible respective (14).

10. Agencement selon l'une quelconque des revendications 7 à 9, **caractérisé en ce qu'**il est prévu une ou plusieurs cassettes (33) servant au rangement desdits objets (23), les cassettes (33) étant rangées dans l'un des différents conteneurs (13).

11. Agencement selon l'une quelconque des revendications 1 à 10, **caractérisé en ce qu'**il est prévu un sas d'accès (22), le sas d'accès (22) étant raccordé à l'armoire de rangement (24).

12. Agencement selon la revendication 11, **caractérisé en ce que** le sas d'accès (22) comprend un système de verrouillage.

13. Utilisation d'un agencement (10) selon l'une quelconque des revendications 1 à 12 pour le rangement de plaquettes (23), en particulier pour le rangement de plaquettes ayant un diamètre allant jusqu'à 300 mm et plus.

# FIG 1

FIG 2